(19) Europäisches Patentamt
European Patent Office
Office européen des brevets

(11) **EP 3 590 166 B1**

(12) **EUROPÄISCHE PATENTSCHRIFT**

(45) Veröffentlichungstag und Bekanntmachung des Hinweises auf die Patenterteilung:
**08.12.2021 Patentblatt 2021/49**

(21) Anmeldenummer: **18709309.1**

(22) Anmeldetag: **28.02.2018**

(51) Int Cl.:
*H02H 3/40* (2006.01)　　　*G01R 31/08* (2020.01)
*H02H 7/26* (2006.01)　　　*H02H 7/28* (2006.01)

(86) Internationale Anmeldenummer:
**PCT/EP2018/054923**

(87) Internationale Veröffentlichungsnummer:
**WO 2018/158312 (07.09.2018 Gazette 2018/36)**

(54) **VERFAHREN ZUR BESTIMMUNG EINES FEHLERORTS IN EINEM ELEKTRISCHEN NETZ MIT RINGSTRUKTUR**

METHOD FOR DETERMINING THE SITE OF A FAULT IN A SUPPLY NETWORK WITH A RING TOPOLOGY

PROCÉDÉ DE LOCALISATION D'UN DÉFAUT DANS UN RÉSEAU ÉLECTRIQUE À STRUCTURE ANNULAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.03.2017 DE 102017104274**

(43) Veröffentlichungstag der Anmeldung:
**08.01.2020 Patentblatt 2020/02**

(73) Patentinhaber: **Friedrich-Alexander-Universität Erlangen-Nürnberg**
**91054 Erlangen (DE)**

(72) Erfinder:
• **JÄGER, Johann**
  **91058 Erlangen (DE)**
• **BILLER, Martin**
  **90461 Nürnberg (DE)**

(74) Vertreter: **Dr. Gassner & Partner mbB**
**Wetterkreuz 3**
**91058 Erlangen (DE)**

(56) Entgegenhaltungen:
CN-A- 103 149 503　　　CN-A- 105 891 673
CN-U- 203 481 822　　　DE-T2- 60 018 666
US-A1- 2006 097 728

**Beschreibung**

Die Erfindung betrifft ein Verfahren zur Bestimmung eines Fehlerorts in einem elektrischen Netz mit Ringstruktur.

Das Dokument DE 600 18 666 T2 offenbart ein Verfahren zur rechnergestützten Ermittlung der Entfernung eines Erdschlusses in einem Übertragungsnetz elektrischer Energie, welches in einer Ringstruktur verbunden ist, unter Verwendung numerischer Messdaten, erhalten mittels eines Multifunktions-Schutzrelais. Dabei wird ein Fehler erfasst und der fehlerbehaftete Abgang identifiziert. Der fehlerhafte Abgang wird in Form einer Ringschleife mit einem der gesunden Abgänge verbunden. Die Nullspannung, die Strangspannungen und die Nullströme der in der Schleife verbundenen Abgänge werden gemessen. Nach den Messungen wird die Schleife geöffnet. Die Phasen der Messsignale werden auf die Außenleiterspannungen bezogen und Frequenzen, die verschieden von der Grundfrequenz sind, werden ausgefiltert, woraufhin die Effektivwerte der Signale auf der Basis der erhaltenen Grundfrequenzanteile dieser Signale berechnet werden. Der fehlerbehaftete Abgang darf getrennt werden.

Weitere Verfahren zur Fehlerermittlung werden in den Dokumenten CN 105 891 673 A, CN 103 149 503 A, US 2006/097728 A1 und CN 203 481 822 U offenbart.

Ein elektrisches Netz wird üblicherweise auf der Mittelspannungsebene als sogenannter offener Ring betrieben.

Heutzutage werden im zunehmenden Ausmaß dezentrale Energieumwandlungsanlagen (DEA) insbesondere im Bereich der Mittelspannungsebene angeschlossen. Infolgedessen werden elektrische Netze zunehmend bis an ihre Betriebsgrenzen belastet. Um diesen Nachteil entgegenzuwirken, werden die offenen Ringe geschlossen. Es ergibt sich dann ein vermaschtes elektrisches Netz, welches eine höhere Aufnahmefähigkeit für DEA aufweist.

Im Falle des Schließens der offenen Ringe funktionieren allerdings herkömmliche Schutzsysteme teilweise nicht mehr.

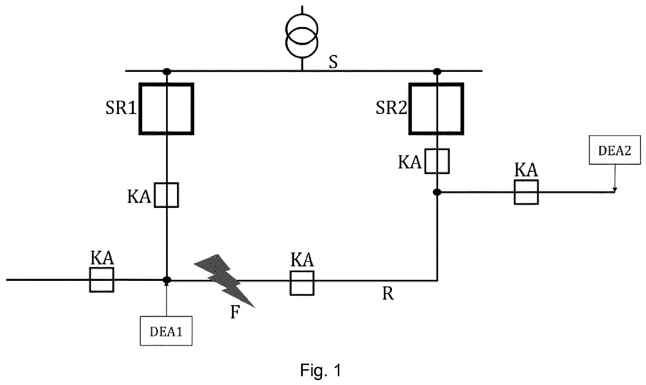

Fig. 1 zeigt ein Netz mit einem geschlossenen Ring R, an welchem zwei dezentrale Energieumwandlungsanlagen DEA1 und DEA2 angeschlossen sind. Die beiden Äste des Rings R sind an einer Sammelschiene S jeweils unter Zwischenschaltung eines Schutzgeräts SR1 sowie SR2 angeschlossen. Ferner ist das Netz mit einer Vielzahl an ungerichteten Kurzschlussanzeigern KA versehen. - Sofern ein Fehler F auftritt, kann wegen der beidseitigen Fehlerspeisung der fehlerhafte Leitungsabschnitt nicht mehr unter Zuhilfenahme der ungerichteten Kurzschlussanzeiger KA isoliert werden. Abgesehen davon wird die Messung einer Distanz zwischen den Schutzgeräten SR1, SR2 und dem Fehler durch den sogenannten Blinding-Effekt, welcher durch die DEA1 sowie DEA2 hervorgerufen wird, und im Falle von Fehlerwiderständen auch durch die gegenüberliegende Einspeisung beeinträchtig. Ein Kurzschlussbeitrag der DEA1 und DEA2 hängt häufig vom Wetter und der Tageszeit ab. Er kann zwischen 0% und 100% schwanken. Abgesehen davon müssen DEA während eines Fehlers F gemäß den Vorgaben der Verteilnetzbetreiber und anderen Richtlinien einen definierten Kurzschlussbeitrag leisten. Das wiederum führt dazu, dass sich die Messung der Schutzgeräte SR1, SR2 bei Auftreten des Fehlers F ändern kann. Sowohl Reaktanz als auch Resistanz entsprechen oftmals nicht mehr dem tatsächlichen Anteil an der physikalischen Impedanz zwischen einem Einbauort eines Schutzgeräts SR1, SR2 und dem Ort des Fehlers F. Infolgedessen kann die Distanz zwischen den Schutzgeräten SR1, SR2 und dem Fehlerort häufig nicht mehr korrekt abgeschätzt werden. Das wiederrum führt zu einer Verzögerung einer Behebung des Fehlers F und einer Wiederversorgung des Rings R mit elektrischem Strom.

Aufgabe der Erfindung ist es, die Nachteile nach dem Stand der Technik zu beseitigen. Es soll insbesondere ein Verfahren angegeben werden, welches in einem elektrischen Netz mit Ringstruktur eine sichere und zuverlässige Bestimmung eines Fehlerorts ermöglicht. Das Verfahren soll nach einem weiteren Ziel der Erfindung möglichst einfach und kostengünstig durchführbar sein. Insbesondere soll das kostenaufwendige Verlegen neuer Leitungen oder dgl. vermieden werden.

Diese Aufgabe wird durch die Merkmale des Patentanspruchs 1 gelöst. Zweckmäßige Ausgestaltungen der Erfindung ergeben sich aus den Merkmalen der Patentansprüche 2 bis 10.

Nach Maßgabe der Erfindung wird ein Verfahren zur Bestimmung eines Fehlerorts in einem elektrischen Netz mit Ringstruktur, vorgeschlagen,

wobei die Ringstruktur zumindest zwei, jeweils über ein Schutzgerät mit einer Sammelschiene verbundene Abgänge (A, B) und eine die zumindest zwei Abgänge (A, B) verbindende Verbindung umfasst,

wobei eine Abhängigkeit eines Orts auf der Ringstruktur von einer Gegensystemresistanz und/oder Gegensystemreaktanz der Ringstruktur vorgegeben ist,

wobei eine Länge eines Fehlerpfads durch den Abstand zwischen einem Fehlerort und einem Schutzgerät definiert ist,

wobei zur Durchführung des Verfahrens die Methode der symmetrischen Komponenten verwendet wird, bei welcher ein unsymmetrisches Mehrphasensystem von Phasoren in ein symmetrisches Mitsystem, ein Gegensystem und ein Nullsystem aufgeteilt wird, und wobei bei einer Überschreitung eines vorgegebenen Schwellwerts einer Gegenstromanregung an einem Schutzgerät die folgenden Schritte ausgeführt werden:

Berechnen eines in das Gegensystem hineinfließenden Gesamtfehlerstroms $I_{F(2)}$, Messung eines im Fehlerpfad fließenden Teilfehlerstroms ($I_{A(2)}$, $I_{B(2)}$) mittels zumindest eines der mit dem Fehlerpfad verbunden Schutzgeräte und Berechnung einer sich daraus und dem Gesamtfehlerstrom $I_F(2)$ ergebenden Vorfehlerimpedanz, wobei die Vorfehlerimpedanz ($Z_{A,vor}$, $Z_{B,vor}$) eine Impedanz zwischen einem der Schutzgeräte und einem Ort ist, an welchem der Gesamtfehlerstrom $I_{F(2)}$ in die Ringstruktur hineinfließt,
Berechnung einer Teil-Gegensystemresistanz- oder Teil-Gegensystemreaktanz des Fehlerpfads unter Verwendung der Vorfehlerimpedanz ($Z_{A,vor}$, $Z_{B,vor}$), und Ermittlung des Fehlerorts (i) aus der Teil-Gegensystemresistanz unter Verwendung der vorgegebenen Abhängigkeit des Orts auf der Ringstruktur von der Gegensystemresistanz ($R_{A,vor}$) oder (ii) aus der Teil-Gegensystemreaktanz unter Verwendung der vorgegebenen Abhängigkeit des Orts auf der Ringstruktur von der Gegensystemreaktanz ($X_{A,vor}$) der Ringstruktur.

Nach dem vorgeschlagenen Verfahren wird der Fehlerort eines unsymmetrischen Fehlers aus dem in das Gegensystem hineinfließenden Gesamtfehlerstrom sowie anhand der Aufteilung des Gesamtfehlerstroms im Ring ermittelt. Dazu kann in zumindest einem der Fehlerpfade der darin fließende Teilfehlerstrom gemessen und daraus die sich ergebende Vorfehlerimpedanz berechnet werden. Aus der Vorfehlerimpedanz kann die dazu korrespondierende Teil-Gegensystemresistanz oder die Teil-Gegensystemreaktanz des Fehlerpfads berechnet werden. Unter Verwendung einer bekannten Abhängigkeit des Orts auf der Ringstruktur von der Gegensystemresistanz oder der Gegensystemreaktanz kann dann der Fehlerort ermittelt werden.

Bei dem vorgeschlagenen Verfahren spielen in vorteilhafter Weise die durch dezentrale Energieumwandlungsanlagen (DEA) hervorgerufenen Störeinflüsse keine Rolle. Das vorgeschlagene Verfahren kann in einfacher und kostengünstiger Weise in herkömmliche Schutzgeräte in Form eines Computerprogramms implementiert werden. Das Verfahren ermöglicht eine schnelle, effiziente und relativ genaue Bestimmung eines Fehlerorts in einem elektrischen Netz mit Ringstruktur.

In vielen Fällen sind die zur Absicherung einer Ringstruktur vorgesehenen Schutzgeräte räumlich nahe beieinander angeordnet. In diesen Fällen ist es ohne großen Aufwand möglich, die Schutzgeräte zum Austausch von Messwerten zu koppeln. Je nachdem ob die Schutzgeräte zum Austausch von Messwerten gekoppelt sind oder nicht kann der ins Gegensystem hineinfließende Gesamtfehlerstrom berechnet werden

a) bei einer Kopplung der beiden Schutzgeräte zum Austausch von Messwerten gemäß der folgenden Beziehung:

$$I_{F(2)} = I_{A(2)} + I_{B(2)}$$

oder
bei nicht zum Austausch von Messwerten gekoppelten Schutzgeräten gemäß der folgenden Beziehung:

$$\underline{I}_{F(2)} = \frac{-\underline{U}_{(2)}}{\underline{Z}_{T(2)} + \underline{Z}_{N(2)}},$$

wobei $\underline{U}_{(2)}$ eine Gegensystemspannung, $\underline{Z}_{N(2)}$ eine vorgegebene Gegensysteminnenimpedanz und $\underline{Z}_{T(2)}$ eine vorgegebene Transformatorgegensystemimpedanz ist.

Die Beiträge $\underline{\delta}_X$ der parallelen Abgänge (A, B) zum Gesamtfehlerstrom ($I_{F(2)}$) ergeben sich zweckmäßigerweise aus der folgenden Beziehung:

$$\underline{\delta}_X = \frac{\underline{I}_{X(2)}}{\underline{I}_{F(2)}}.$$

Wenn eine mehrere Bereiche aufweisende Topologie des Netzes vorbekannt ist, wobei ein Bereich ein Pfad zwischen einem Schutzgerät und einem Referenzknoten oder ein Pfad zwischen zwei Referenzknoten ist, kann ein mit dem Fehler behafteter Fehlerbereich ($F_A$, $F_B$, Fc) der Bereiche aus den in die Bereiche hineinfließenden Teilfehlerströmen ermittelt werden.

Nach einer weiteren Ausgestaltung des Verfahrens wird die Vorfehlerimpedanz auf der Grundlage eines zur Anzahl der parallelen Abgänge (A, B) korrespondierenden Gegensystemersatzschaltbilds berechnet.

Die Vorfehlerimpedanz ergibt sich bei zwei parallelen Abgängen (A, B) vorteilhafterweise aus einer der folgenden Beziehungen:

$$\underline{Z}_{A,vor} = \left(1 - \underline{\delta}_A\right) \cdot \sum \underline{Z}_A \ ,$$

$$\underline{Z}_{B,vor} = \left(1 - \underline{\delta}_B\right) \cdot \sum \underline{Z}_B \ ,$$

Bei mehr als zwei parallelen Abgängen (A, B, C, D) wird zweckmäßigerweise zur Ermittlung der Vorfehlerimpedanz das Gegensystemersatzschaltbild durch ein Ersatzschaltbild ersetzt, in welchem die nicht mit dem Fehler behafteten Bereiche zu einem Fehlerpfad mit einer Restimpedanz $\underline{Z}_{Rest,x}$ zusammengefasst werden.

Die Vorfehlerimpedanz ergibt sich bei drei parallelen Abgängen (A, B, C) vorteilhafterweise aus einer der folgenden Beziehungen:

Fehlerbereich A: $\underline{Z}_{A,vor} = (1 - \underline{\delta}_A) \cdot (\Sigma \underline{Z}_A + \underline{Z}_{Rest,A})$, wobei $\underline{Z}_{Rest,A} = \Sigma \underline{Z}_B \| \Sigma \underline{Z}_C$

Fehlerbereich B: $\underline{Z}_{B,vor} = (1 - \underline{\delta}_B) \cdot (\Sigma \underline{Z}_B + \underline{Z}_{Rest,B})$, wobei $\underline{Z}_{Rest,B} = \Sigma \underline{Z}_A \| \Sigma \underline{Z}_C$

Fehlerbereich C: $\underline{Z}_{C,vor} = (1 - \underline{\delta}_C) \cdot (\Sigma \underline{Z}_C + \underline{Z}_{Rest,C})$, wobei $\underline{Z}_{Rest,C} = \Sigma \underline{Z}_A \| \Sigma \underline{Z}_B$

Bei vier parallelen Abgängen (A, B, C, D) ergibt sich vorteilhafterweise die Vorfehlerimpedanz aus einer der folgenden Gleichungen:

| Fehlerbereich | Gleichung |
|---|---|
| A | $\underline{Z}_{A,vor} = \left(1 - \underline{\delta}_A\right) \cdot \left(\sum \underline{Z}_A + \underline{Z}_{Rest,A}\right),$ wobei $$\underline{Z}_{Rest,A} = \sum \underline{Z}_B \left\| \left(\sum \underline{Z}_{AB\_CD} + \left(\sum \underline{Z}_C \| \sum \underline{Z}_D\right)\right)\right.$$ |
| B | $\underline{Z}_{B,vor} = \left(1 - \underline{\delta}_B\right) \cdot \left(\sum \underline{Z}_B + \underline{Z}_{Rest,B}\right),$ wobei $$\underline{Z}_{Rest,B} = \sum \underline{Z}_A \left\| \left(\sum \underline{Z}_{AB\_CD} + \left(\sum \underline{Z}_C \| \sum \underline{Z}_D\right)\right)\right.$$ |
| C | $\underline{Z}_{C,vor} = \left(1 - \underline{\delta}_C\right) \cdot \left(\sum \underline{Z}_C + \underline{Z}_{Rest,C}\right),$ wobei $$\underline{Z}_{Rest,C} = \sum \underline{Z}_D \left\| \left(\sum \underline{Z}_{AB\_CD} + \left(\sum \underline{Z}_A \| \sum \underline{Z}_B\right)\right)\right.$$ |
| D | $\underline{Z}_{D,vor} = \left(1 - \underline{\delta}_D\right) \cdot \left(\sum \underline{Z}_D + \underline{Z}_{Rest,D}\right),$ wobei $$\underline{Z}_{Rest,D} = \sum \underline{Z}_C \left\| \left(\sum \underline{Z}_{AB\_CD} + \left(\sum \underline{Z}_A \| \sum \underline{Z}_B\right)\right)\right.$$ |
| AB_CD | $\underline{Z}_{AB\_CD,vor} = \sum \underline{Z}_{AB\_CD} + \underline{Z}_{C\|D} - \left(\underline{\delta}_A + \underline{\delta}_B\right) \cdot \left(\underline{Z}_{A\|B} + \sum \underline{Z}_{AB\_CD} + \underline{Z}_{C\|D}\right),$ wobei $$\underline{Z}_{A\|B} = \sum \underline{Z}_A \| \sum \underline{Z}_B \ ; \ \underline{Z}_{C\|D} = \sum \underline{Z}_C \| \sum \underline{Z}_D$$ |

Die die Ringstruktur bildende Verbindung ist zweckmäßigerweise ein im Schließzustand befindlicher Schalter. Eine solche Schaltung unter Verwendung eines Schalters ist bei herkömmlichen Mittelspannungsnetzen ohnehin bereits vorhanden. Durch Schließen des Schalters kann die Ringstruktur erzeugt werden.

Nachfolgend wird die Erfindung anhand von Ausführungsbeispielen und der Zeichnung näher erläutert. In der Zeichnung zeigen:

Fig. 1 ein elektrisches Netz mit einer herkömmlichen Ringstruktur,

Fig. 2a, 2b ein Flussdiagramm des erfindungsgemäßen Verfahrens,

Fig. 3 den Fehlerort in über der Resistanz bzw. Reaktanz,

Fig. 4 ein Gegensystemersatzschaltbild zur Berechnung der Vorfehlerimpedanz bei 2 parallelen Abgängen,

Fig. 5 ein Gegensystemersatzschaltbild zur Berechnung der Vorfehlerimpedanz bei 3 parallelen Abgängen,

Fig. 6 ein Gegensystemersatzschaltbild zur Berechnung der Vorfehlerimpedanz bei 4 parallelen Abgängen und

Fig. 7 ein Gegensystemersatzschaltbild zur Berechnung der Vorfehlerimpedanz bei 5 und mehr parallelen Abgängen.

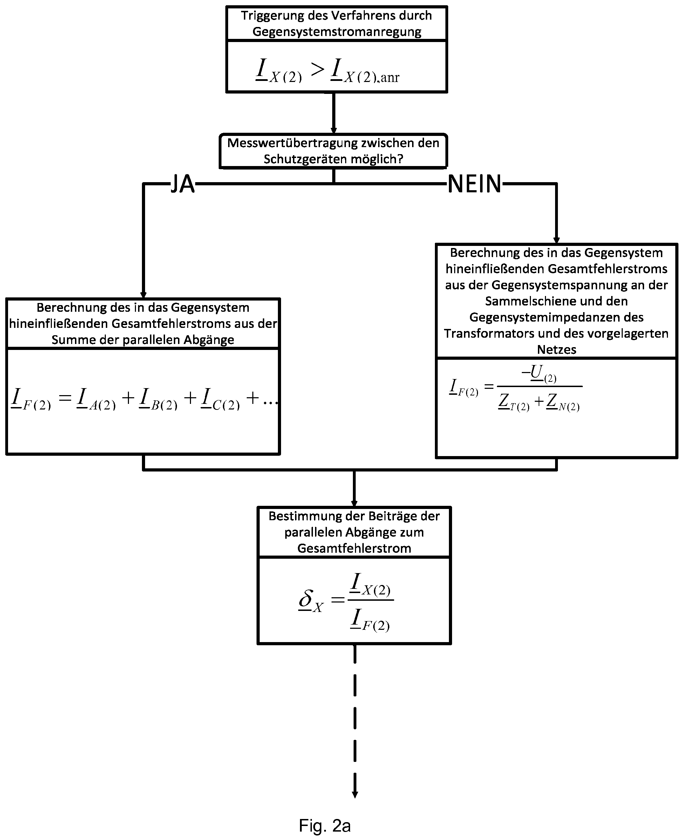

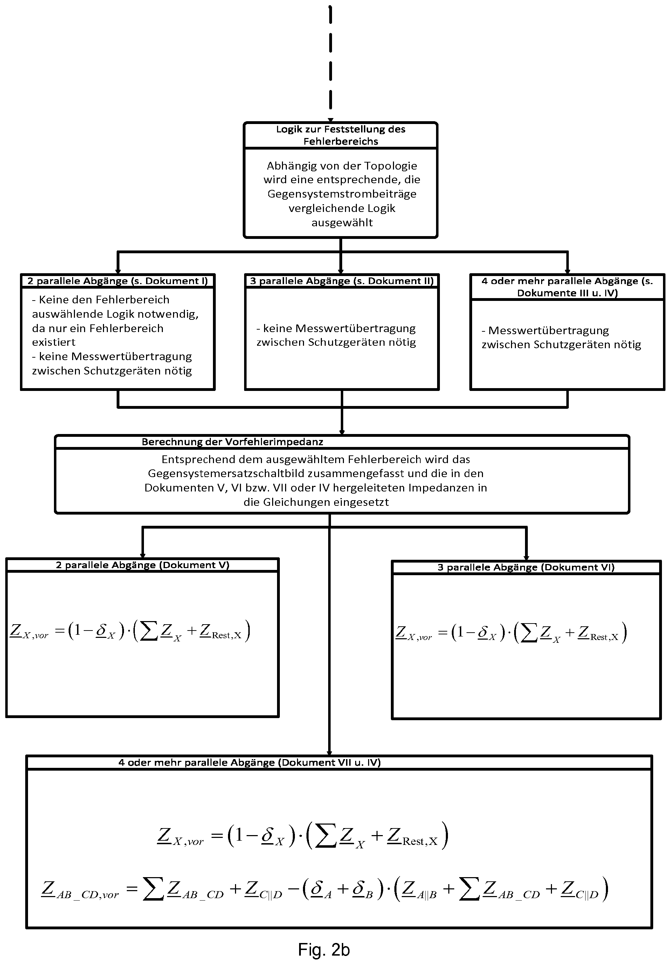

Die Fig. 2a und 2b zeigen in einem Flussdiagramm eine Ausgestaltung des erfindungsgemäßen Verfahrens. Das erfindungsgemäße Verfahren kann insbesondere als Computerprogramm in einem Schutzgerät implementiert sein. Das Verfahren kann infolgedessen als Computerprogrammprodukt ausgestaltet sein, welches auf einem Datenträger gespeichert oder von einem Datenträger herunterladbar ist.

Nach dem erfindungsgemäßen Verfahren wird beispielsweise mittels eines entsprechend hergerichteten Schutzgeräts, ständig die Gegensystemstromanregung gemessen. Sofern der im Gegensystem fließende Gegenstrom $I_{X(2)}$ größer ist als eine vorgegebene Gegensystemstromschwelle $I_{X(2), anr}$, werden die im Flussdiagramm gezeigten nachfolgenden Schritte durchgeführt.

In einem nächsten Schritt kann dann geprüft werden, ob zwischen den an einer Sammelschiene angeschlossenen Schutzgeräten eine Messwertübertragung möglich ist oder nicht. Dieser Schritt kann auch durch eine feste Voreinstellung im Computerprogramm entbehrlich sein.

Sofern eine Messwertübertragung zwischen den Schutzgeräten möglich ist, erfolgt die Berechnung des in das Gegensystem hineinfließenden Gesamtfehlerstroms $\underline{I}_{F(2)}$ aus der Summe der Fehlerströme $\underline{I}_{A(2)}$, $\underline{I}_{B(2)}$, $\underline{I}_{C(2)}$ aller parallelen Abgänge A, B, C.

Sofern eine Messwertübertragung zwischen den Schutzgeräten nicht stattfindet, erfolgt die Berechnung des in das Gegensystem hineinfließende Gesamtfehlerstroms aus der Gegensystemspannung $\underline{U}_{(2)}$ an der Sammelschiene und den Gegensystemimpedanzen des Transformators $\underline{Z}_{T(2)}$ und des vorgelagerten Netzes $\underline{Z}_{N(2)}$.

In einem nächsten Schritt erfolgt nach der dort angegebenen Beziehung die Bestimmung der Beiträge $\underline{\delta}_x$ der parallelen Abgänge A, B, C zum Gesamtfehlerstrom $\underline{I}_{F(2)}$.

In einem nächsten Schritt wird mittels einer vorgegebenen Logik in Abhängigkeit einer mehrere Bereiche aufweisenden, vorgegebenen Topologie des Netzes der mit dem Fehler behaftete Bereich bzw. Fehlerbereich ermittelt. Die Logik zur Feststellung des Fehlerbereichs richtet sich nach der Anzahl der parallelen Abgänge. Sie ist nicht erforderlich, wenn lediglich zwei parallele Abgänge vorhanden sind. In diesem Fall ist auch eine Messwertübertragung zwischen den Schutzgeräten nicht erforderlich.

Die Logik ist bei drei und mehr parallelen Abgängen erforderlich. Sofern lediglich drei parallele Abgänge vorliegen, ist keine Messwertübertragung zwischen den Schutzgeräten erforderlich. Bei vier oder mehr parallelen Abgängen ist zusätzlich eine Messwertübertragung zwischen den Schutzgeräten erforderlich.

Je nach der ausgewählten Logik wird sodann die Vorfehlerimpedanz $\underline{Z}_{A,vor}$, $\underline{Z}_{B,vor}$, ... für jeden der parallelen Abgänge A, B, ... berechnet.

In einem weiteren, nicht in Fig. 2 gezeigten Schritt, wird sodann unter Verwendung der Vorfehlerimpedanz $\underline{Z}_{A,vor}$, $\underline{Z}_{B,vor}$, eine Teil-Gegensystemresistanz oder eine Teil-Gegensystemreaktanz des Fehlerpfads berechnet.

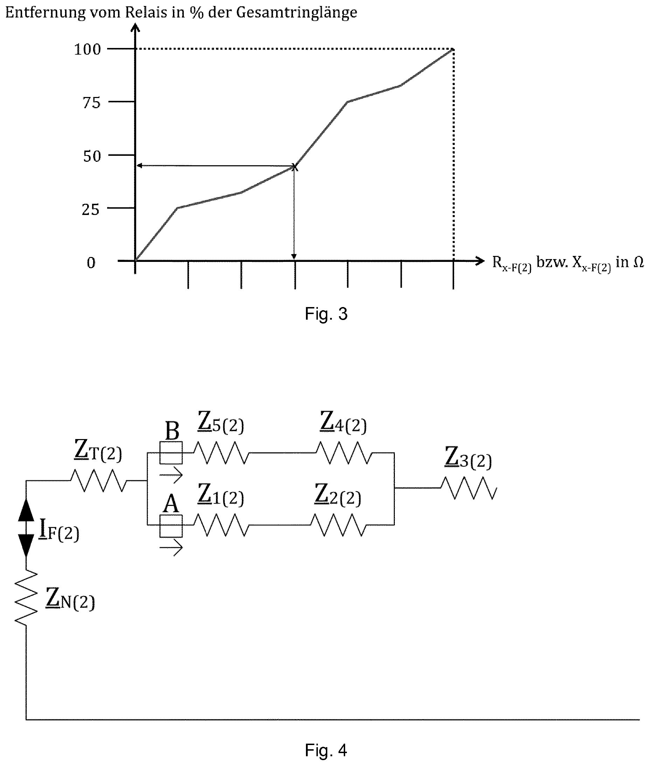

In einem weiteren, nicht in Fig. 2 gezeigten Schritt, kann sodann der Fehlerort aus der Teil-Gegensystemresistanz unter Verwendung einer vorgegebenen Abhängigkeit des Orts auf der Ringstruktur von der Gegensystemresistanz oder aus der Teil-Gegensystemreaktanz unter Verwendung der vorgegebenen Abhängigkeit des Orts auf der Ringstruktur von der Gegensystemreaktanz der Ringstruktur ermittelt werden. Die Abhängigkeit des Orts der Ringstruktur von der Gegensystemresistanz bzw. Gegensystemreaktanz ist beispielhaft in Fig. 3 gezeigt.

Nachfolgend wird die Berechnung der Vorfehlerimpedanzen in Abhängigkeit der Anzahl der parallelen Abgänge näher erläutert.

Zur Berechnung der Vorfehlerimpedanz bei zwei parallelen Abgängen erfolgt zunächst eine Berechnung der Größen $\sum \underline{Z}_X$ und $\underline{Z}_{\text{Rest},X}$ aus dem in Fig. 4 gezeigten Gegensystemersatzschaltbild

$$\sum \underline{Z}_A = \sum \underline{Z}_B = \underline{Z}_{1(2)} + \underline{Z}_{2(2)} + \underline{Z}_{4(2)} + \underline{Z}_{5(2)}$$

$$\underline{Z}_{\text{Rest},A} = \underline{Z}_{\text{Rest},B} = 0$$

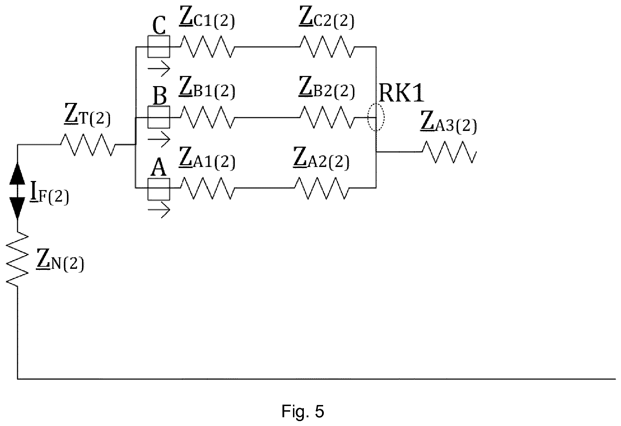

Zur Berechnung der Vorfehlerimpedanz bei 3 parallelen Abgängen erfolgt eine Berechnung der Größen $\sum \underline{Z}_X$ und $\underline{Z}_{\text{Rest},X}$ aus dem in Fig. 5 gezeigten Gegensystemersatzschaltbild.

Nomenklatur/Definitionen:

- Fehlerbereich A, B, C: Bereich zwischen Schutzgerät und Referenzknoten
- Referenzknoten: Knoten, welcher drei Fehlerbereiche miteinander verbindet und nicht die Sammelschiene ist.
- Die Pfeile unter den Schutzgeräten geben die Vorwärtsrichtung des Stromes an

RK1: Bezeichnung des Referenzknotens

$$\sum \underline{Z}_A = \underline{Z}_{A1(2)} + \underline{Z}_{A2(2)}$$

$$\sum \underline{Z}_B = \underline{Z}_{B1(2)} + \underline{Z}_{B2(2)}$$

$$\sum \underline{Z}_C = \underline{Z}_{C1(2)} + \underline{Z}_{C2(2)}$$

$$\underline{Z}_{\text{Rest},A} = \sum \underline{Z}_B \, \| \, \sum \underline{Z}_C$$

$$\underline{Z}_{\text{Rest},B} = \sum \underline{Z}_A \, \| \, \sum \underline{Z}_C$$

$$\underline{Z}_{\text{Rest},C} = \sum \underline{Z}_A \, \| \, \sum \underline{Z}_B$$

Die Auswahl in welchem Abgang der Fehler liegt, d.h. welche Vorfehlerimpedanz $\underline{Z}_{X,vor}$ berechnet werden soll, hängt vom Realteil des Fehlerstrombeitrags der einzelnen Abgänge ab. Durch eine Berechnung des Realteils der Fehlerstrombeiträge für einen Fehler an RK1 werden Referenzwerte $\delta_{re,ref,A}; \delta_{re,ref,B}; \delta_{re,ref,C}$ bestimmt. Diese werden anschließend mit den Messwerten $\delta_{re,A}; \delta_{re,B}; \delta_{re,C}$ verglichen.

Gemäß folgender Logik wird entschieden:

| Fehlerbereich | $\delta_{re,A} <> \delta_{re,ref,A}$ | $\delta_{re,B} <> \delta_{re,ref,B}$ | $\delta_{re,C} <> \delta_{re,ref,C}$ |
|---|---|---|---|
| A | > | Egal | Egal |
| B | Egal | > | Egal |
| C | Egal | Egal | > |

Die Logik zeigt, dass eine Kenntnis der Fehlerstrombeiträge der anderen Abgänge nicht erforderlich ist, um zu entscheiden, in welchem Fehlerbereich der Fehler liegt.

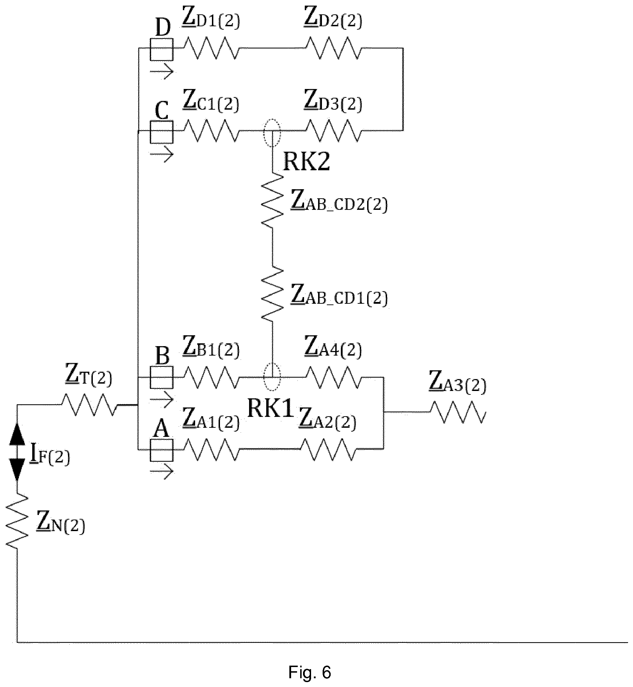

Zur Berechnung der Vorfehlerimpedanz bei 4 parallelen Abgängen erfolgt eine Berechnung der Größen $\sum \underline{Z}_X$ und $\underline{Z}_{\text{Rest},X}$ aus dem in Fig. 6 gezeigten Gegensystemersatzschaltbild.

Nomenklatur/Definitionen:

- Fehlerbereich A, B, C, D, AB_CD: Bereich zwischen Schutzgerät und Referenzknoten bzw. zwischen zwei Referenzknoten
- Referenzknoten: Knoten, welcher drei Fehlerbereiche miteinander verbindet und nicht die Sammelschiene ist.
- Die Pfeile unter den Schutzgeräten geben die Vorwärtsrichtung des Stromes an

RK1, RK2: Bezeichnung der Referenzknoten

$$\sum \underline{Z}_A = \underline{Z}_{A1(2)} + \underline{Z}_{A2(2)} + \underline{Z}_{A4(2)}$$

$$\sum \underline{Z}_B = \underline{Z}_{B1(2)}$$

$$\sum \underline{Z}_C = \underline{Z}_{C1(2)}$$

$$\sum \underline{Z}_D = \underline{Z}_{D1(2)} + \underline{Z}_{D2(2)} + \underline{Z}_{D3(2)}$$

$$\sum \underline{Z}_{AB\_CD} = \underline{Z}_{AB\_CD1(2)} + \underline{Z}_{AB\_CD2(2)}$$

$$\underline{Z}_{\mathrm{Rest},A} = \sum \underline{Z}_B \,\|\, \left( \sum \underline{Z}_{AB\_CD} + \left( \sum \underline{Z}_C \,\|\, \sum \underline{Z}_D \right) \right)$$

$$\underline{Z}_{\mathrm{Rest},B} = \sum \underline{Z}_A \,\|\, \left( \sum \underline{Z}_{AB\_CD} + \left( \sum \underline{Z}_C \,\|\, \sum \underline{Z}_D \right) \right)$$

$$\underline{Z}_{\mathrm{Rest},C} = \sum \underline{Z}_D \,\|\, \left( \sum \underline{Z}_{AB\_CD} + \left( \sum \underline{Z}_A \,\|\, \sum \underline{Z}_B \right) \right)$$

$$\underline{Z}_{\mathrm{Rest},D} = \sum \underline{Z}_C \,\|\, \left( \sum \underline{Z}_{AB\_CD} + \left( \sum \underline{Z}_A \,\|\, \sum \underline{Z}_B \right) \right)$$

$$\underline{Z}_{A\|B} = \sum \underline{Z}_A \,\|\, \sum \underline{Z}_B$$

$$\underline{Z}_{C\|D} = \sum \underline{Z}_C \,\|\, \sum \underline{Z}_D$$

Die Auswahl, in welchem Abgang der Fehler liegt, d.h. welche Vorfehlerimpedanz $\underline{Z}_{X,vor}$ berechnet werden soll, hängt vom Realteil des Fehlerstrombeitrags der einzelnen Abgänge ab. Durch eine Berechnung des Realteils Fehlerstrombeiträge für einen Fehler an RK1 werden Referenzwerte $\delta_{re,ref,A}; \delta_{re,ref,B}; \delta_{re,ref,C}; \delta_{re,ref,D}$ bestimmt. Diese werden anschließend mit den Messwerten $\delta_{re,A}; \delta_{re,B}; \delta_{re,C}; \delta_{re,D}$ bzw. $\underline{\delta}_C; \underline{\delta}_D$ verglichen.

Der Fehlerbereich wird nach der folgenden Logik ermittelt:

| Fehlerbereich | $\delta_{re,A} <> \delta_{re,ref}$ | $\delta_{re,B} <> \delta_{re,ref,B}$ | $\delta_{re,C} <> \delta_{re,ref,C}$ | $\delta_{re,D} <> \delta_{re,ref,D}$ | $\mathrm{Re}\left\{\dfrac{\underline{\delta}_C}{\underline{\delta}_D}\right\} <> \mathrm{Re}\left\{\dfrac{\underline{\delta}_{ref,C}}{\underline{\delta}_{ref,D}}\right\}$ |
|---|---|---|---|---|---|
| A | > | Egal | Egal | Egal | Egal |
| B | Egal | > | Egal | Egal | Egal |
| C | Egal | Egal | > | Egal | > |
| D | Egal | Egal | Egal | > | < |
| AB-CD | Egal | Egal | > | > | = |

Nachfolgend wird die Logik zur Feststellung des Fehlerbereichs in Abhängigkeit der Anzahl der parallelen Abgänge näher erläutert.

1. Zur Ermittlung des Fehlerbereichs bei zwei parallelen Abgängen werden vorteilhafterweise die folgenden Schritte durchgeführt:

1.1. Anregung

a. Anregung erfolgt über $I_{(2)>}$-Anregung. Ist der $I_{(2)}$-Schwellwert in einem der vier Pfade überschritten, wird die Fehlerortung angestoßen.

1.2. Fehlerortung

a. Berechnung von
$$\underline{\delta}_X = \frac{\underline{I}_{X(2)}}{\underline{I}_{F(2)}}$$

b. $\underline{I}_{F(2)}$ kann auf zwei Arten berechnet werden: $\underline{I}_{F(2)} = \underline{I}_{A(2)} + \underline{I}_{B(2)}$ oder
$$\underline{I}_{F(2)} = \frac{-\underline{U}_{(2)}}{\underline{Z}_{T(2)} + \underline{Z}_{N(2)}}$$

1.3. Gleichungen zur Berechnung der Vorfehlerimpedanz (Impedanz am Ring zwischen Schutzgerät und Fehlerort)

| Fehlerbereich | Gleichung |
|---|---|
| A=B | $\underline{Z}_{A,vor} = (1 - \underline{\delta}_A) \cdot \Sigma \underline{Z}_A$ |
| B=A | $\underline{Z}_{B,vor} = (1 - \underline{\delta}_B) \cdot \Sigma \underline{Z}_B$ |

Zu beachten ist, dass unter $\Sigma \underline{Z}_A$ bzw. $\Sigma \underline{Z}_B$ die Summe der Impedanzen auf direktem Weg zwischen den beiden Schutzgeräten eingesetzt wird. Abzweige gehen nicht in die Summe ein.

2. Zur Ermittlung des Fehlerbereichs bei 3 parallelen Abgängen werden vorteilhafterweise die folgenden Schritte durchgeführt:

2.1. Anregung

a. Anregung erfolgt über $I_{(2)>}$-Anregung. Ist der $I_{(2)}$-Schwellwert in einem der vier Pfade überschritten, wird die Fehlerortung ausgelöst.

2.2. Fehlerortung

a. Berechnung aller $\underline{\delta}_X = \dfrac{\underline{I}_{X(2)}}{\underline{I}_{F(2)}}$

b. $\underline{I}_{F(2)}$ kann auf zwei Arten berechnet werden: $\underline{I}_{F(2)} = \underline{I}_{A(2)} + \underline{I}_{B(2)} + \underline{I}_{C(2)}$ oder $\underline{I}_{F(2)} = \dfrac{-\underline{U}_{(2)}}{\underline{Z}_{T(2)} + \underline{Z}_{N(2)}}$

c. Vergleich von $\delta_{re,X} = \mathrm{Re}\left\{\dfrac{\underline{I}_{X(2)}}{\underline{I}_{F(2)}}\right\}$ mit $\delta_{re,ref,X} = \mathrm{Re}\{\delta_{ref,X}\}$

d. $\delta_{re,ref,X}$ gibt den reellen Anteil am Gegensystemfehlerstrom wieder, welcher bei einem Kurzschlussereignis am Referenzknoten durch Schutzgerät X fließt. $\delta_{re,ref,X}$ wird offline berechnet und im Schutzgerät als Parameter eingetragen.

e. Aus den Abweichungen der insgesamt drei $\delta_{re,X}$ gegenüber dem jeweiligen $\delta_{re,ref,X}$ wird festgestellt, ob der Strang des betrachteten Schutzgeräts vom Fehler betroffen ist. Der Referenzknoten liegt hierbei exemplarisch am Knoten A-B-AB_CD (RK1)

f. Sollten alle Abweichungen betragsmäßig kleiner als ein bestimmter Wert (z.B. 1%) sein, so ist das Fehlereignis am Referenzknoten.

g. Zwischen zwei Referenzknoten darf neben dem Weg über die Sammelschiene nur ein Pfad existieren, Ansonsten kann aufgrund der Gegensystemstromaufteilung bei Fehlern zwischen den Referenzknoten keine sichere Aussage für den Fehlerort getroffen werden.

| Fehlerbereich | $\delta_{re,A} <> \delta_{re,ref,A}$ | $\delta_{re,B} <> \delta_{re,ref,B}$ | $\delta_{re,C} <> \delta_{re,ref,C}$ |
|---|---|---|---|
| A | > | Egal | Egal |
| B | Egal | > | Egal |
| C | Egal | Egal | > |

2.3. Gleichungen zur Berechnung der Vorfehlerimpedanz (Impedanz am Ring zwischen Schutzgerät und Fehlerort)

| Fehlerbereich | Gleichung |
|---|---|
| A | $\underline{Z}_{A,vor} = \left(1 - \underline{\delta}_A\right)\cdot\left(\sum \underline{Z}_A + \underline{Z}_{\mathrm{Rest},A}\right)$ |
| B | $\underline{Z}_{B,vor} = \left(1 - \underline{\delta}_B\right)\cdot\left(\sum \underline{Z}_B + \underline{Z}_{\mathrm{Rest},B}\right)$ |
| C | $\underline{Z}_{C,vor} = \left(1 - \underline{\delta}_C\right)\cdot\left(\sum \underline{Z}_C + \underline{Z}_{\mathrm{Rest},C}\right)$ |
| Fehlerbereich | Anmerkungen |
| A | $\underline{Z}_{\mathrm{Rest},A} = \sum \underline{Z}_B \,\|\, \sum \underline{Z}_C$ |
| B | $\underline{Z}_{\mathrm{Rest},B} = \sum \underline{Z}_A \,\|\, \sum \underline{Z}_C$ |
| C | $\underline{Z}_{\mathrm{Rest},C} = \sum \underline{Z}_A \,\|\, \sum \underline{Z}_B$ |

Zu beachten ist, dass unter $\Sigma\underline{Z}_X$ die Summe der Impedanzen auf direktem Wege zwischen dem Relais und dem Referenzknoten eingesetzt wird. Abzweige gehen nicht in die Summe ein.

3. Zur Ermittlung des Fehlerbereichs bei 4 parallelen Abgängen werden vorteilhafterweise die folgenden Schritte durchgeführt:

3.1. Anregung

a. Anregung erfolgt über I(2)>-Anregung. Ist der I(2)-Schwellwert in einem der vier Pfade überschritten, wird die Fehlerortung angestoßen.

### 3.2. Fehlerortung

$$\underline{\delta}_X = \frac{\underline{I}_{X(2)}}{\underline{I}_{F(2)}}$$

a. Berechnung aller

b. $\underline{I}_{F(2)}$ kann auf zwei Arten berechnet werden: $\underline{I}_{F(2)} = \underline{I}_{A(2)} + \underline{I}_{B(2)} + \underline{I}_{C(2)} + \underline{I}_{D(2)}$ oder

$$\underline{I}_{F(2)} = \frac{-\underline{U}_{(2)}}{\underline{Z}_{T(2)} + \underline{Z}_{N(2)}}$$

$$\delta_{re,X} = \mathrm{Re}\left\{\frac{\underline{I}_{X(2)}}{\underline{I}_{F(2)}}\right\}$$

c. Vergleich von   mit $\delta_{re,ref,X} = \mathrm{Re}\{\delta_{ref,X}\}$

d. $\delta_{re,ref,X}$ gibt den reellen Anteil am Gegensystemfehlerstrom wieder, der bei einem Kurzschlussereignis am Referenzknoten durch Relais X fließt. $\delta_{re,ref,X}$ wird offline berechnet und im Schutzgerät als Parameter eingetragen.

e. Aus den Abweichungen der insgesamt vier $\delta_{re,X}$ gegenüber den jeweiligen $\delta_{re,ref,X}$ wird die gemäß der folgenden Logik die dem Fehlerbereich entsprechende Gleichung ausgewählt.

Der Referenzknoten liegt hierbei exemplarisch am Knoten A-B-AB_CD (RK1)

f. Sollten alle Abweichungen betragsmäßig kleiner als ein bestimmter Wert (z.B. 1%) sein, so ist das Fehlereignis am Referenzknoten.

g. Zwischen zwei Referenzknoten darf neben dem Weg über die Sammelschiene nur ein Pfad existieren. Ansonsten kann aufgrund der Gegensystemstromaufteilung bei Fehlern zwischen den Referenzknoten keine sichere Aussage für den Fehlerort getroffen werden.

| Fehlerbereich | $\delta_{re,A}$ <> $\delta_{re,ref,A}$ | $\delta_{re,B}$ <> $\delta_{re,ref,B}$ | $\delta_{re,C}$ <> $\delta_{re,ref,C}$ | $\delta_{re,D}$ <> $\delta_{re,ref,D}$ | $\mathrm{Re}\left\{\dfrac{\underline{\delta}_C}{\underline{\delta}_D}\right\}$ <> $\mathrm{Re}\left\{\dfrac{\underline{\delta}_{ref,C}}{\underline{\delta}_{ref,D}}\right\}$ |
|---|---|---|---|---|---|
| A | > | Egal | Egal | Egal | Egal |
| B | Egal | > | Egal | Egal | Egal |
| C | Egal | Egal | > | Egal | > |
| D | Egal | Egal | Egal | > | < |
| AB-CD | Egal | Egal | > | > | = |

### 3.3. Gleichungen zur Berechnung der Vorfehlerimpedanz (Impedanz am Ring zwischen Schutzgerät und Fehlerort)

| A | $\underline{Z}_{A,vor} = (1 - \underline{\delta}_A) \cdot (\sum \underline{Z}_A + \underline{Z}_{Rest,A})$ |
|---|---|
| B | $\underline{Z}_{B,vor} = (1 - \underline{\delta}_B) \cdot (\sum \underline{Z}_B + \underline{Z}_{Rest,B})$ |
| c | $\underline{Z}_{C,vor} = (1 - \underline{\delta}_C) \cdot (\sum \underline{Z}_C + \underline{Z}_{Rest,C})$ |
| D | $\underline{Z}_{D,vor} = (1 - \underline{\delta}_D) \cdot (\sum \underline{Z}_D + \underline{Z}_{Rest,D})$ |
| AB_CD | $\underline{Z}_{AB\_CD,vor} = \sum \underline{Z}_{AB\_CD} + \underline{Z}_{C\|D} - (\underline{\delta}_A + \underline{\delta}_B) \cdot (\underline{Z}_{A\|B} + \sum \underline{Z}_{AB\_CD} + \underline{Z}_{C\|D})$ |

| Fehlerbereich | Anmerkungen |
|---|---|
| A | $\underline{Z}_{\text{Rest},A} = \Sigma \underline{Z}_B \| (\Sigma \underline{Z}_{AB\_CD} + (\Sigma \underline{Z}_C \| \Sigma \underline{Z}_D))$ |
| B | $\underline{Z}_{\text{Rest},B} = \Sigma \underline{Z}_A \| (\Sigma \underline{Z}_{AB\_CD} + (\Sigma \underline{Z}_C \| \Sigma \underline{Z}_D))$ |
| C | $\underline{Z}_{\text{Rest},C} = \Sigma \underline{Z}_D \| (\Sigma \underline{Z}_{AB\_CD} + (\Sigma \underline{Z}_A \| \Sigma \underline{Z}_B))$ |
| D | $\underline{Z}_{\text{Rest},D} = \Sigma \underline{Z}_C \| (\Sigma \underline{Z}_{AB\_CD} + (\Sigma \underline{Z}_A \| \Sigma \underline{Z}_B))$ |
| AB_CD | $\underline{Z}_{A\|B} = \Sigma \underline{Z}_A \| \Sigma \underline{Z}_B$<br>$\underline{Z}_{C\|D} = \Sigma \underline{Z}_C \| \Sigma \underline{Z}_D$ |

Zu beachten ist, dass unter $\Sigma \underline{Z}_X$ die Summe der Impedanzen auf direktem Wege zwischen dem Schutzgerät und dem Referenzknoten eingesetzt wird. Abzweige gehen nicht in die Summe ein.

4. Zur Berechnung der Vorfehlerimpedanz und zur Ermittlung des Fehlerbereichs bei 5 oder mehr parallelen Abgängen werden folgende Schritte durchgeführt.

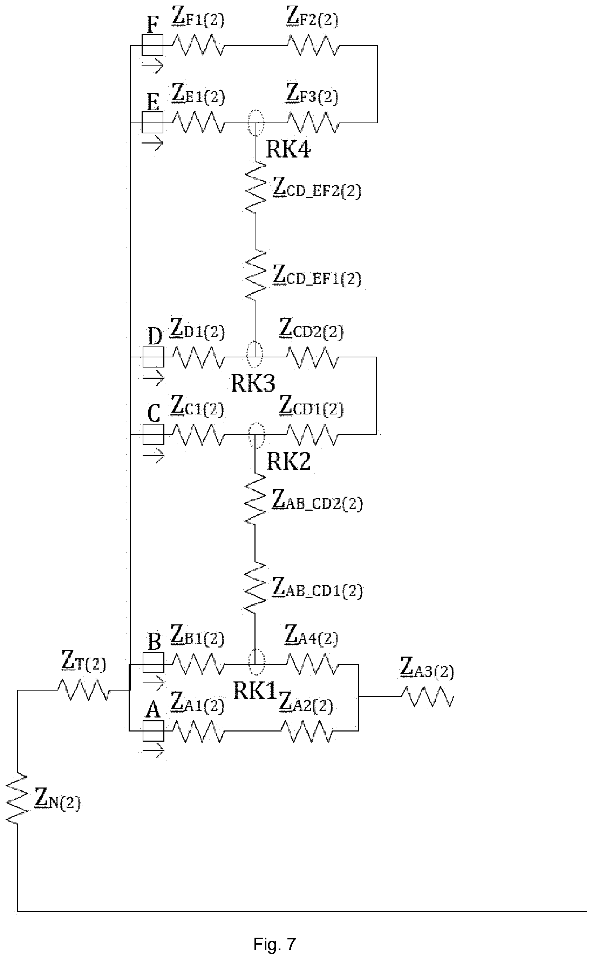

Die Berechnung der Größen $\Sigma \underline{Z}_X$ und $\underline{Z}_{\text{Rest},X}$ erfolgt aus dem in Fig. 7 gezeigten Gegensystemersatzschaltbild

Nomenklatur/Definitionen:

- Fehlerbereich A, B, C, D, E, F, AB_CD, CD_EF: Bereich zwischen Schutzgerät und Referenzknoten bzw. zwischen zwei Referenzknoten
- Referenzknoten: Knoten, welcher drei Fehlerbereiche miteinander verbindet und nicht die Sammelschiene ist.
- Die Pfeile unter den Schutzgeräten geben die Vorwärtsrichtung des Stroms an

RK1, RK2, RK3, RK4: Bezeichnung der Referenzknoten

$$\sum \underline{Z}_A = \underline{Z}_{A1(2)} + \underline{Z}_{A2(2)} + \underline{Z}_{A4(2)}$$

$$\sum \underline{Z}_B = \underline{Z}_{B1(2)}$$

$$\sum \underline{Z}_C = \underline{Z}_{C1(2)}$$

$$\sum \underline{Z}_D = \underline{Z}_{D1(2)}$$

$$\sum \underline{Z}_E = \underline{Z}_{E1(2)}$$

$$\sum \underline{Z}_F = \underline{Z}_{F1(2)} + \underline{Z}_{F2(2)} + \underline{Z}_{F3(2)}$$

$$\sum \underline{Z}_{CD} = \underline{Z}_{CD1(2)} + \underline{Z}_{CD2(2)}$$

$$\sum \underline{Z}_{AB\_CD} = \underline{Z}_{AB\_CD1(2)} + \underline{Z}_{AB\_CD2(2)}$$

$$\sum \underline{Z}_{CD\_EF} = \underline{Z}_{CD\_EF1(2)} + \underline{Z}_{CD\_EF2(2)}$$

Die Zusammenfassung des Netzwerks zu den Restimpedanzen $\underline{Z}_{\text{Rest},X}$ erfolgt analog zur Betrachtung der 4 parallelen Abgänge. Gleiches gilt für die Berechnung der Vorfehlerimpedanzen $\underline{Z}_{X,vor}$

Die Auswahl, in welchem Abgang der Fehler liegt, d.h. welche Vorfehlerimpedanz $\underline{Z}_{X,vor}$ berechnet werden soll, hängt vom Realteil des Fehlerstrombeitrags der einzelnen Abgänge ab. Durch eine Berechnung des Realteils Fehlerstrombeiträge für je einen Fehler an RK1 und RK3 werden Referenzwerte $\delta_{re,ref,A}; \delta_{re,ref,B}; \delta_{re,ref,C}; \delta_{re,ref,D}; \delta_{re,ref,E}; \delta_{re,ref,F}$ bestimmt. Diese werden anschließend mit den Messwerten

$\delta_{re,A}; \delta_{re,B}; \delta_{re,C}; \delta_{re,D}; \delta_{re,E}; \delta_{re,F}$ bzw. $\underline{\delta}_A; \underline{\delta}_B; \underline{\delta}_C; \underline{\delta}_D; \underline{\delta}_E; \underline{\delta}_F$ verglichen.

Mit einem Vergleich der Fehlerstrombeiträge links und rechts eines Referenzknotens kann festgestellt werden, auf welcher Seite sich der Fehlerort befindet. Mithilfe eines Vergleichs der Fehlerstrombeiträge auf der fehlerhaften Seite kann der Bereich eingegrenzt werden. Somit kann das Netz auf eine 4-Abgangs-Darstellung reduziert werden und der Fehlerort lokalisiert werden.

Beispielhafte Vorgehensweise:

- Referenzknoten RK1 mit Priorität 1, RK3 mit Priorität 2

$$\mathrm{Re}\left\{\frac{\underline{\delta}_A + \underline{\delta}_B}{\underline{\delta}_C + \underline{\delta}_D + \underline{\delta}_E + \underline{\delta}_F}\right\} < \mathrm{Re}\left\{\frac{\underline{\delta}_{A,ref,RK1} + \underline{\delta}_{B,ref,RK1}}{\underline{\delta}_{C,ref,RK1} + \underline{\delta}_{D,ref,RK1} + \underline{\delta}_{E,ref,RK1} + \underline{\delta}_{F,ref,RK1}}\right\}$$

- Wenn ist, dann liegt der Fehler im Fehlerbereich C,D,E,F,AB_CD oder CD_EF
- Dann folgt ein Vergleich der Fehlerstrombeiträge mit den Referenzwerten für RK3.

$$\mathrm{Re}\left\{\frac{\underline{\delta}_C + \underline{\delta}_D}{\underline{\delta}_E + \underline{\delta}_F}\right\} < \mathrm{Re}\left\{\frac{\underline{\delta}_{C,ref,RK3} + \underline{\delta}_{D,ref,RK3}}{\underline{\delta}_{E,ref,RK3} + \underline{\delta}_{F,ref,RK3}}\right\}$$

- Wenn ist, dann liegt der Fehler im Fehlerbereich E,F oder CD_EF.

$$\mathrm{Re}\left\{\frac{\underline{\delta}_E}{\underline{\delta}_F}\right\} < \mathrm{Re}\left\{\frac{\underline{\delta}_{E,ref,RK3}}{\underline{\delta}_{F,ref,RK3}}\right\}$$

- Ist nun das Verhältnis , so liegt der Fehler im Fehlerbereich F. Für

$$\mathrm{Re}\left\{\frac{\underline{\delta}_E}{\underline{\delta}_F}\right\} > \mathrm{Re}\left\{\frac{\underline{\delta}_{E,ref,RK3}}{\underline{\delta}_{F,ref,RK3}}\right\} \quad \mathrm{Re}\left\{\frac{\underline{\delta}_E}{\underline{\delta}_F}\right\} = \mathrm{Re}\left\{\frac{\underline{\delta}_{E,ref,RK3}}{\underline{\delta}_{F,ref,RK3}}\right\}$$

liegt der Fehler im Fehlerbereich E. Für liegt der Fehler im Fehlerbereich CD_EF.

Durch solch eine Vorgehensweise kann der Fehlerbereich gefunden, die nicht fehlerhaften Fehlerbereiche zusammengefasst und die Vorfehlerimpedanz $\underline{Z}_{X,vor}$ berechnet werden.

Einschränkung:

Besteht zwischen zwei Referenzknoten bzw. zwischen einem Referenzknoten und der Sammelschiene mehr als ein direkter Pfad (d.h. ohne dabei andere Referenzknoten zu passieren), so können Fehler in diesem Fehlerbereich aufgrund der Parallelschaltung nicht lokalisiert werden.

**Patentansprüche**

1. Verfahren zur Bestimmung eines Fehlerorts in einem elektrischen Netz mit Ringstruktur,

    wobei die Ringstruktur zumindest zwei, jeweils über ein Schutzgerät mit einer Sammelschiene verbundene Abgänge (A, B) und eine die zumindest zwei Abgänge (A, B) verbindende Verbindung umfasst,
    wobei eine Abhängigkeit eines Orts auf der Ringstruktur von einer Gegensystemresistanz und/oder Gegensystemreaktanz der Ringstruktur vorgegeben ist,
    wobei eine Länge eines Fehlerpfads durch den Abstand zwischen einem Fehlerort und einem Schutzgerät definiert ist,
    wobei zur Durchführung des Verfahrens die Methode der symmetrischen Komponenten verwendet wird, bei welcher ein unsymmetrisches Mehrphasensystem von Phasoren in ein symmetrisches Mitsystem, ein Gegensystem und ein Nullsystem aufgeteilt wird, und wobei bei einer Überschreitung eines vorgegebenen Schwellwerts einer Gegenstromanregung an einem Schutzgerät die folgenden Schritte ausgeführt werden:

    Berechnen eines in das Gegensystem hineinfließenden Gesamtfehlerstroms $\underline{I}_{F(2)}$,
    Messung eines im Fehlerpfad fließenden Teilfehlerstroms ($\underline{I}_{A(2)}$, $\underline{I}_{B(2)}$) mittels zumindest eines der mit dem Fehlerpfad verbunden Schutzgeräte und Berechnung einer sich daraus und dem Gesamtfehlerstrom $\underline{I}_{F(2)}$ ergebenden Vorfehlerimpedanz, wobei die Vorfehlerimpedanz ($\underline{Z}_{A,vor}$, $\underline{Z}_{B,vor}$) eine Impedanz zwischen einem der Schutzgeräte und einem Ort ist, an welchem der Gesamtfehlerstrom $\underline{I}_{F(2)}$ in die Ringstruktur hineinfließt,
    Berechnung einer Teil-Gegensystemresistanz- oder Teil-Gegensystemreaktanz des Fehlerpfads unter Ver-

wendung der Vorfehlerimpedanz ($\underline{Z}_{A,vor}$, $\underline{Z}_{B,vor}$), und

Ermittlung des Fehlerorts (i) aus der Teil-Gegensystemresistanz unter Verwendung der vorgegebenen Abhängigkeit des Orts auf der Ringstruktur von der Gegensystemresistanz ($R_{A,vor}$) oder (ii) aus der Teil-Gegensystemreaktanz unter Verwendung der vorgegebenen Abhängigkeit des Orts auf der Ringstruktur von der Gegensystemreaktanz ($X_{A,vor}$) der Ringstruktur.

**2.** Verfahren nach Anspruch 1, wobei der ins Gegensystem hineinfließende Gesamtfehlerstrom $\underline{I}_{F(2)}$ berechnet wird

a) bei einer Kopplung der beiden Schutzgeräte zum Austausch von Messwerten gemäß der folgenden Beziehung:

$$\underline{I}_{F(2)} = \underline{I}_{A(2)} + \underline{I}_{B(2)}$$

oder

b) bei nicht zum Austausch von Messwerten gekoppelten Schutzgeräten gemäß der folgenden Beziehung:

$$\underline{I}_{F(2)} = \frac{-\underline{U}_{(2)}}{\underline{Z}_{T(2)} + \underline{Z}_{N(2)}},$$

wobei $\underline{U}_{(2)}$ eine Gegensystemspannung, $\underline{Z}_{N(2)}$ eine vorgegebene Gegensysteminnenimpedanz und $\underline{Z}_{T(2)}$ eine vorgegebene Transformatorgegensystemimpedanz ist.

**3.** Verfahren nach einem der vorhergehenden Ansprüche, wobei die Beiträge $\underline{\delta}_x$ der parallelen Abgänge (A, B) zum Gesamtfehlerstrom ($\underline{I}_{F(2)}$) sich aus der folgenden Beziehung ergibt:

$$\underline{\delta}_X = \frac{\underline{I}_{X(2)}}{\underline{I}_{F(2)}}.$$

**4.** Verfahren nach einem der vorhergehenden Ansprüche, wobei eine mehrere Bereiche Topologie des Netzes vorbekannt ist, wobei ein Bereich ein Pfad zwischen einem Schutzgerät und einem Referenzknoten (RK1) oder ein Pfad zwischen zwei Referenzknoten (RK1, RK2, RK3, RK4) ist, und wobei ein mit dem Fehler behafteter Fehlerbereich ($F_A$, $F_B$, Fc) der Bereiche aus den in die Bereiche hineinfließenden Teilfehlerströmen ermittelt wird.

**5.** Verfahren nach einem der vorhergehenden Ansprüche, wobei die Vorfehlerimpedanz auf der Grundlage eines zur Anzahl der parallelen Abgänge (A, B) korrespondierenden Gegensystemersatzschaltbilds berechnet wird.

**6.** Verfahren nach einem der vorhergehenden Ansprüche, wobei sich die Vorfehlerimpedanz bei zwei parallelen Abgängen (A, B) aus einer der folgenden Beziehungen ergibt:

$$\underline{Z}_{A,vor} = \left(1 - \underline{\delta}_A\right) \cdot \sum \underline{Z}_A,$$

$$\underline{Z}_{B,vor} = \left(1 - \underline{\delta}_B\right) \cdot \sum \underline{Z}_B,$$

**7.** Verfahren nach einem der vorhergehenden Ansprüche, wobei bei mehr als zwei parallelen Abgängen (A, B, C, D) zur Ermittlung der Vorfehlerimpedanz das Gegensystemersatzschaltbild durch eine Ersatzschaltbild ersetzt wird, in welchem die nicht mit dem Fehler behafteten Bereiche zu einem Fehlerpfad mit einer Restimpedanz $\underline{Z}_{Rest,x}$ zusammengefasst werden.

**8.** Verfahren nach einem der vorhergehenden Ansprüche, wobei sich die Vorfehlerimpedanz bei drei parallelen Abgängen (A, B, C) aus einer der folgenden Beziehung ergibt:

Fehlerbereich A: $Z_{A,vor} = (1 - \underline{\delta}_A) \cdot (\sum \underline{Z}_A + \underline{Z}_{Rest,A})$, wobei $\underline{Z}_{Rest,A} = \sum \underline{Z}_B \| \sum \underline{Z}_C$

Fehlerbereich B: $\underline{Z}_{B,vor} = (1-\underline{\delta}_B)\cdot(\Sigma\underline{Z}_B + \underline{Z}_{Rest,B})$, wobei $\underline{Z}_{Rest,B} = \Sigma\underline{Z}_A \| \Sigma\underline{Z}_C$

Fehlerbereich C: $\underline{Z}_{C,vor} = (1-\underline{\delta}_C)\cdot(\Sigma\underline{Z}_C + \underline{Z}_{Rest,C})$, wobei $\underline{Z}_{Rest,C} = \Sigma\underline{Z}_A \| \Sigma\underline{Z}_B$

9. Verfahren nach einem der vorhergehenden Ansprüche, wobei sich die Vorfehlerimpedanz bei vier parallelen Abgängen (A, B, C, D) aus einer der folgenden Gleichungen ergibt:

| Fehlerbereich | Gleichung |
|---|---|
| A | $$\underline{Z}_{A,vor} = \left(1-\underline{\delta}_A\right)\cdot\left(\sum\underline{Z}_A + \underline{Z}_{Rest,A}\right), \text{wobei}$$ $$\underline{Z}_{Rest,A} = \sum\underline{Z}_B \left\| \left(\sum\underline{Z}_{AB\_CD} + \left(\sum\underline{Z}_C \| \sum\underline{Z}_D\right)\right)\right.$$ |
| B | $$\underline{Z}_{B,vor} = \left(1-\underline{\delta}_B\right)\cdot\left(\sum\underline{Z}_B + \underline{Z}_{Rest,B}\right), \text{wobei}$$ $$\underline{Z}_{Rest,B} = \sum\underline{Z}_A \left\| \left(\sum\underline{Z}_{AB\_CD} + \left(\sum\underline{Z}_C \| \sum\underline{Z}_D\right)\right)\right.$$ |
| C | $$\underline{Z}_{C,vor} = \left(1-\underline{\delta}_C\right)\cdot\left(\sum\underline{Z}_C + \underline{Z}_{Rest,C}\right), \text{wobei}$$ $$\underline{Z}_{Rest,C} = \sum\underline{Z}_D \left\| \left(\sum\underline{Z}_{AB\_CD} + \left(\sum\underline{Z}_A \| \sum\underline{Z}_B\right)\right)\right.$$ |
| D | $$\underline{Z}_{D,vor} = \left(1-\underline{\delta}_D\right)\cdot\left(\sum\underline{Z}_D + \underline{Z}_{Rest,D}\right), \text{wobei}$$ $$\underline{Z}_{Rest,D} = \sum\underline{Z}_C \left\| \left(\sum\underline{Z}_{AB\_CD} + \left(\sum\underline{Z}_A \| \sum\underline{Z}_B\right)\right)\right.$$ |
| AB_CD | $$\underline{Z}_{AB\_CD,vor} = \sum\underline{Z}_{AB\_CD} + \underline{Z}_{C\|D} - \left(\underline{\delta}_A + \underline{\delta}_B\right)\cdot\left(\underline{Z}_{A\|B} + \sum\underline{Z}_{AB\_CD} + \underline{Z}_{C\|D}\right), \text{wobei}$$ $$\underline{Z}_{A\|B} = \sum\underline{Z}_A \| \sum\underline{Z}_B \; ; \; \underline{Z}_{C\|D} = \sum\underline{Z}_C \| \sum\underline{Z}_D$$ |

10. Verfahren nach einem der vorhergehenden Ansprüche, wobei die Verbindung ein im Schließzustand befindlicher Schalter ist.

## Claims

1. Method for determining a fault location in an electrical network with a ring structure,

   wherein the ring structure comprises at least two outgoing feeders (A, B), each connected to a busbar via a protective device, and a connection connecting the at least two outgoing feeders (A, B),
   wherein a dependence of a location on the ring structure on a counter system resistance and/or counter system reactance of the ring structure is predetermined,
   wherein a length of a fault path is defined by the distance between a fault location and a protection device,
   wherein the method of symmetrical components is used for carrying out the method, in which an asymmetrical multi-phase system of phasors is divided into a symmetrical co-system, a counter-system and a zero-system, and wherein the following steps are carried out when a predetermined threshold value of a countercurrent excitation at a protective device is exceeded:

calculating a total error current $\underline{I}_{F(2)}$ flowing into the negative sequence,
measurement of a partial fault current ($\underline{I}_{A(2)}$, $\underline{I}_{B(2)}$) flowing in the fault path by means of at least one of the protection devices connected to the fault path, and calculation of a pre-fault impedance resulting therefrom and from the total fault current $\underline{I}_{F(2)}$, the pre-fault impedance ($\underline{Z}_{A,vor}$, $\underline{Z}_{B,vor}$) being an impedance between one of the protection devices and a location at which the total fault current $_{IF(2)}$ flows into the ring structure, calculating a partial counter system resistance or partial counter system reactance of the fault path using the pre-fault impedance ($\underline{Z}_{A,vor}$, $\underline{Z}_{B,vor}$), and
determining the fault location (i) from the counter system resistance using the predetermined dependence of the location on the ring structure on the counter system resistance ($R_{A,vor}$) or (ii) from the partial counter system reactance using the predetermined dependence of the location on the ring structure on the counter system reactance ($X_{A,vor}$) of the ring structure.

2. Method according to claim 1, wherein the total fault current $\underline{I}_{F(2)}$ flowing into the counter system is calculated

a) when the two protection devices are coupled to exchange measured values in accordance with the following relationship:

$$\underline{I}_{F(2)} = \underline{I}_{A(2)} + \underline{I}_{B(2)}$$

or
b) for protection devices not coupled for the exchange of measured values, in accordance with the following relationship:

$$\underline{I}_{F(2)} = \frac{-\underline{U}_{(2)}}{\underline{Z}_{T(2)} + \underline{Z}_{N(2)}},$$

where $\underline{U}_{(2)}$ is a counter system voltage, $\underline{Z}_{N(2)}$ is a predetermined counter system internal impedance, and $\underline{Z}_{T(2)}$ is a predetermined transformer counter system impedance.

3. Method according to any one of the preceding claims, wherein the contributions $\underline{\delta}_x$ of the parallel feeders (A, B) to the total fault current ($\underline{I}_{F(2)}$) are obtained from the following relationship:

$$\underline{\delta}_X = \frac{\underline{I}_{X(2)}}{\underline{I}_{F(2)}}.$$

4. Method according to any one of the preceding claims, wherein a plurality of regions topology of the network is known in advance, wherein a region is a path between a protection device and a reference node (RK1) or a path between two reference nodes (RK1, RK2, RK3, RK4), and wherein a fault region ($F_A$, $F_B$, $F_C$) of the regions affected by the fault is determined from the partial fault currents flowing into the regions.

5. Method according to any one of the preceding claims, wherein the pre-fault impedance is calculated on the basis of a counter system equivalent circuit corresponding to the number of parallel feeders (A, B).

6. Method according to any one of the preceding claims, wherein the pre-fault impedance for two parallel feeders (A, B) is obtained from one of the following relationships:

$$\underline{Z}_{A,vor} = \left(1 - \underline{\delta}_A\right) \cdot \sum \underline{Z}_A,$$

$$\underline{Z}_{B,vor} = \left(1 - \underline{\delta}_B\right) \cdot \sum \underline{Z}_B,$$

7. Method according to one of the preceding claims, wherein, in the case of more than two parallel feeders (A, B, C, D) for determining the pre-fault impedance, the counter system equivalent circuit is replaced by an equivalent circuit in which the regions not affected by the fault are combined to form a fault path with a residual impedance $\underline{Z}_{Rest,x}$.

8. Method according to any one of the preceding claims, wherein the pre-fault impedance at three parallel feeders (A, B, C) is obtained from one of the following relationships:

Error Range A: $\underline{Z}_{A,vor} = (1 - \underline{\delta}_A) \cdot (\Sigma \underline{Z}_A + \underline{Z}_{Rest,A})$, whereby

$$\underline{Z}_{Rest,A} = \sum \underline{Z}_B \,||\, \sum \underline{Z}_C$$

Error Range B: $\underline{Z}_{B,vor} = (1 - \underline{\delta}_B) \cdot (\Sigma \underline{Z}_B + \underline{Z}_{Rest,B}())$, whereby

$$\underline{Z}{\sum \underline{Z}_A \,||\, \sum \underline{Z}_C}{}_{Rest,B}$$

Error Range C: $\underline{Z}_{C,vor} = (1 - \underline{\delta}_C) \cdot (\Sigma \underline{Z}_C + \underline{Z}_{Rest,C}())$, whereby

$$\underline{Z}_{Rest,C} = \sum \underline{Z}_A \,||\, \sum \underline{Z}_B$$

9. Method according to any one of the preceding claims, wherein the pre-fault impedance at four parallel feeders (A, B, C, D) is obtained from one of the following equations:

| Error Range | Equation |
|---|---|
| A | $\underline{Z}_{A,vor} = (1 - \underline{\delta}_A) \cdot \left( \Sigma \underline{Z}_A + \underline{Z}_{Rest,A} \right)$, whereby $$\underline{Z}_{Rest,A} = \sum \underline{Z}_B \,||\, \left( \sum \underline{Z}_{AB\_CD} + \left( \sum \underline{Z}_C \,||\, \sum \underline{Z}_D \right) \right)$$ |
| B | $\underline{Z}_{B,vor} = (1 - \underline{\delta}_B) \cdot \left( \Sigma \underline{Z}_B + \underline{Z}_{Rest,B}() \right)$, whereby $$\underline{Z}_{Rest,B} = \sum \underline{Z}_A \,||\, \left( \sum \underline{Z}_{AB\_CD} + \left( \sum \underline{Z}_C \,||\, \sum \underline{Z}_D \right) \right)$$ |
| C | $\underline{Z}_{C,vor} = (1 - \underline{\delta}_C) \cdot \left( \Sigma \underline{Z}_C + \underline{Z}_{Rest,C}() \right)$, whereby $$\underline{Z}{\sum \underline{Z}_D \,||\, \left( \sum \underline{Z}_{AB\_CD} + \left( \sum \underline{Z}_A \,||\, \sum \underline{Z}_B \right) \right)}{}_{Rest,C}$$ |
| D | $\underline{Z}_{D,vor} = (1 - \underline{\delta}_D) \cdot \left( \Sigma \underline{Z}_D + \underline{Z}_{Rest,D} \right)$, whereby $$\underline{Z}_{Rest,D} = \sum \underline{Z}_C \,||\, \left( \sum \underline{Z}_{AB\_CD} + \left( \sum \underline{Z}_A \,||\, \sum \underline{Z}_B \right) \right)$$ |
| AB_CD | $\underline{Z}_{AB\_CD,vor} = \Sigma \underline{Z}_{AB\_CD} + \underline{Z}_{C||D} - \left( \underline{\delta}_A + \underline{\delta}_B \right) \cdot \left( \underline{Z}_{A||B} + \Sigma \underline{Z}_{AB\_CD} + \underline{Z}_{C||D} \right)$, whereby $$\underline{Z}_{A||B} = \Sigma \underline{Z}_A \,||\, \Sigma \underline{Z}_B; \quad \underline{Z}_{C||D} = \Sigma \underline{Z}_C \,||\, \Sigma \underline{Z}_D$$ |

**10.** Method of any one of the preceding claims, wherein the connection is a switch in the closed state.


**Revendications**

**1.** Procédé de localisation d'un défaut dans un réseau électrique à structure annulaire,

en ce que la structure annulaire comprend au moins deux sorties (A, B) reliées chacune à une barre omnibus par l'intermédiaire d'un appareil de protection et une connexion reliant aux moins les deux sorties (A, B),
en ce qu'une dépendance d'un endroit sur la structure annulaire à l'égard d'une résistance inverse et/ou d'une réactance inverse de la structure annulaire est prédéfinie,
en ce qu'une longueur d'un trajet de défaut sur la distance entre une localisation de défaut et un appareil de protection est définie,
en ce que la méthode des composantes symétriques est utilisée pour mettre en œuvre ledit procédé, méthode selon laquelle un système polyphasé asymétrique de phaseurs est réparti en un système direct symétrique, un système inverse et un système homopolaire, et en cas de dépassement d'une valeur seuil prédéfinie d'une excitation de courant opposé au niveau d'un appareil de protection, les étapes suivantes à effectuer consistent à :

mesurer un courant de défaut total $\underline{I}_{F(2)}$ circulant dans le système inverse,
mesurer un courant de défaut partiel ($\underline{I}_{A(2)}$, $\underline{I}_{B(2)}$) circulant dans le trajet de défaut d'au moins un des appareils de protection reliés au trajet de défaut et calculer une impédance du défaut préalable qui en résulte et résulte du courant de défaut total $\underline{I}_{F(2)}$, en ce que l'impédance de défaut préalable ($\underline{Z}_{A,vor}$, $\underline{Z}_{B,vor}$) est une impédance entre l'un des appareils de protection et un endroit où le courant de défaut total $\underline{I}_{F(2)}$ circule dans la structure annulaire,
calculer une résistance inverse partielle ou une réactance inverse partielle du trajet de défaut au moyen de l'impédance de défaut préalable ($\underline{Z}_{A,vor}$, $\underline{Z}_{B,vor}$), et
localiser le défaut (i) sur la base de la résistance inverse partielle en utilisant la dépendance prédéfinie de l'endroit sur la structure annulaire de la résistance inverse ($R_{A,vor}$) ou (ii) de la réactance inverse partielle en utilisant la dépendance prédéfinie de l'endroit sur la structure annulaire de la réactance inverse ($X_{A,vor}$) de la structure annulaire.

**2.** Procédé selon la revendication 1, en ce que le courant de défaut total $\underline{I}_{F(2)}$ circulant dans le système inverse est calculé

a) dans le cas d'un couplage des deux appareils de protection pour l'échange de mesures selon la relation suivante :

$$\underline{I}_{F(2)} = \underline{I}_{A(2)} + \underline{I}_{B(2)}$$

ou
b) dans le cas d'appareils de protection non couplés pour l'échange de mesures selon la relation suivante :

$$\underline{I}_{F(2)} = \frac{-\underline{U}_{(2)}}{\underline{Z}_{T(2)} + \underline{Z}_{N(2)}},$$

$\underline{U}_{(2)}$ étant une tension système inverse, $\underline{Z}_{N(2)}$ une impédance interne système inverse prédéfinie et $\underline{Z}_{T(2)}$ une impédance système inverse de transformateur prédéfinie.

**3.** Procédé selon l'une des revendications précédentes, en ce que les contributions $\underline{\delta}_X$ des sorties parallèles (A, B) au courant de défaut total ($\underline{I}_{F(2)}$) résultent de la relation suivante :

$$\underline{\delta}_X = \frac{\underline{I}_{X(2)}}{\underline{I}_{F(2)}}.$$

4. Procédé selon l'une des revendications précédentes, en ce qu'une topologie multizone du réseau est déjà connue, en ce qu'une zone est un trajet entre un appareil de protection et un nœud de référence (RK1) ou un trajet entre deux nœuds de référence (RK1, RK2, RK3, RK4), et en ce qu'une zone de défaut ($F_A$, $F_B$, $F_C$) affectée par le défaut des zones est déterminée à partir des courants de défaut partiel circulant dans les zones.

5. Procédé selon l'une des revendications précédentes, en ce que l'impédance de défaut préalable est calculée sur la base d'un circuit équivalent de système inverse correspondant au nombre de sorties parallèles (A, B).

6. Procédé selon l'une des revendications précédentes, en ce que l'impédance de défaut préalable pour deux sorties parallèles (A, B) est obtenue à partir de l'une des relations suivantes :

$$\underline{Z}_{A,vor} = \left(1 - \underline{\delta}_A\right)\cdot \sum \underline{Z}_A \ ,$$

$$\underline{Z}_{B,vor} = \left(1 - \underline{\delta}_B\right)\cdot \sum \underline{Z}_B \ ,$$

7. Procédé selon l'une des revendications précédentes, en ce que le circuit équivalent de système inverse est remplacé par un circuit équivalent pour déterminer l'impédance de défaut préalable en cas de plus de deux sorties parallèles (A, B, C, D), circuit équivalent dans lequel les zones affectées par le défaut sont regroupées en un trajet de défaut avec une impédance résiduelle $\underline{Z}_{Rest,x}$.

8. Procédé selon l'une des revendications précédentes, en ce que l'impédance de défaut préalable pour trois sorties parallèles (A, B, C) est obtenue à partir de l'une des relations suivantes :

Zone de défaut A : $\underline{Z}_{A,vor} = (1 - \underline{\delta}_A)\cdot(\Sigma\underline{Z}_A + \underline{Z}_{Rest,A})$, sachant que $\underline{Z}_{Rest,A} = \Sigma\underline{Z}_B \| \Sigma\underline{Z}_C$
Zone de défaut B : $\underline{Z}_{B,vor} = (1 - \underline{\delta}_B)\cdot(\Sigma\underline{Z}_B + \underline{Z}_{Rest,B})$, sachant que $\underline{Z}_{Rest,B} = \Sigma\underline{Z}_A \| \Sigma\underline{Z}_C$
Zone de défaut C : $\underline{Z}_{C,vor} = (1 - \underline{\delta}_C)\cdot(\Sigma\underline{Z}_C + \underline{Z}_{Rest,C})$, sachant que $\underline{Z}_{Rest,C} = \Sigma\underline{Z}_A \| \Sigma\underline{Z}_B$

9. Procédé selon l'une des revendications précédentes, en ce que l'impédance de défaut préalable pour quatre sorties parallèles (A, B, C, D) est obtenue à partir de l'une des équations suivantes :

| Zone de défaut | Équation |
|---|---|
| A | $$\underline{Z}_{A,vor} = \left(1 - \underline{\delta}_A\right)\cdot\left(\sum\underline{Z}_A + \underline{Z}_{Rest,A}\right)$$ , sachant que $$\underline{Z}_{Rest,A} = \sum\underline{Z}_B \ \| \left(\sum\underline{Z}_{AB\_CD} + \left(\sum\underline{Z}_C \ \| \ \sum\underline{Z}_D\right)\right)$$ |
| B | $$\underline{Z}_{B,vor} = \left(1 - \underline{\delta}_B\right)\cdot\left(\sum\underline{Z}_B + \underline{Z}_{Rest,B}\right)$$ , sachant que $$\underline{Z}_{Rest,B} = \sum\underline{Z}_A \ \| \left(\sum\underline{Z}_{AB\_CD} + \left(\sum\underline{Z}_C \ \| \ \sum\underline{Z}_D\right)\right)$$ |
| C | $$\underline{Z}_{C,vor} = \left(1 - \underline{\delta}_C\right)\cdot\left(\sum\underline{Z}_C + \underline{Z}_{Rest,C}\right)$$ , sachant que $$\underline{Z}_{Rest,C} = \sum\underline{Z}_D \ \| \left(\sum\underline{Z}_{AB\_CD} + \left(\sum\underline{Z}_A \ \| \ \sum\underline{Z}_B\right)\right)$$ |

(suite)

| Zone de défaut | Équation |
|---|---|
| D | $$\underline{Z}_{D,vor} = \left(1 - \underline{\delta}_D\right) \cdot \left(\sum \underline{Z}_D + \underline{Z}_{\text{Rest},D}\right)$$, sachant que $$\underline{Z}_{\text{Rest},D} = \sum \underline{Z}_C \parallel \left(\sum \underline{Z}_{AB\_CD} + \left(\sum \underline{Z}_A \parallel \sum \underline{Z}_B\right)\right)$$ |
| AB_CD | $$\underline{Z}_{AB\_CD,vor} = \sum \underline{Z}_{AB\_CD} + \underline{Z}_{C\parallel D} - \left(\underline{\delta}_A + \underline{\delta}_B\right) \cdot \left(\underline{Z}_{A\parallel B} + \sum \underline{Z}_{AB\_CD} + \underline{Z}_{C\parallel D}\right)$$ $$\underline{Z}_{A\parallel B} = \sum \underline{Z}_A \parallel \sum \underline{Z}_B \; ; \; \underline{Z}_{C\parallel D} = \sum \underline{Z}_C \parallel \sum \underline{Z}_D$$, sachant que |

10. Procédé selon l'une des revendications précédentes en ce que la connexion est un commutateur à l'état fermé.

SR1  SR2

KA  KA

KA  KA

DEA2

KA

KA

R

F

DEA1

S

Fig. 1

Triggerung des Verfahrens durch
Gegensystemstromanregung

$$\underline{I}_{X(2)} > \underline{I}_{X(2),anr}$$

Messwertübertragung zwischen den
Schutzgeräten möglich?

——JA————————————————NEIN———

Berechnung des in das Gegensystem
hineinfließenden Gesamtfehlerstroms aus der
Summe der parallelen Abgänge

$$\underline{I}_{F(2)} = \underline{I}_{A(2)} + \underline{I}_{B(2)} + \underline{I}_{C(2)} + ...$$

Berechnung des in das Gegensystem
hineinfließenden Gesamtfehlerstroms
aus der Gegensystemspannung an der
Sammelschiene und den
Gegensystemimpedanzen des
Transformators und des vorgelagerten
Netzes

$$\underline{I}_{F(2)} = \frac{-\underline{U}_{(2)}}{\underline{Z}_{T(2)} + \underline{Z}_{N(2)}}$$

Bestimmung der Beiträge der
parallelen Abgänge zum
Gesamtfehlerstrom

$$\underline{\delta}_X = \frac{\underline{I}_{X(2)}}{\underline{I}_{F(2)}}$$

Fig. 2a

**Logik zur Feststellung des Fehlerbereichs**

Abhängig von der Topologie wird eine entsprechende, die Gegensystemstrombeiträge vergleichende Logik ausgewählt

---

**2 parallele Abgänge (s. Dokument I)**

- Keine den Fehlerbereich auswählende Logik notwendig, da nur ein Fehlerbereich existiert
- keine Messwertübertragung zwischen Schutzgeräten nötig

**3 parallele Abgänge (s. Dokument II)**

- keine Messwertübertragung zwischen Schutzgeräten nötig

**4 oder mehr parallele Abgänge (s. Dokumente III u. IV)**

- Messwertübertragung zwischen Schutzgeräten nötig

---

**Berechnung der Vorfehlerimpedanz**

Entsprechend dem ausgewähltem Fehlerbereich wird das Gegensystemersatzschaltbild zusammengefasst und die in den Dokumenten V, VI bzw. VII oder IV hergeleiteten Impedanzen in die Gleichungen eingesetzt

---

**2 parallele Abgänge (Dokument V)**

$$\underline{Z}_{X,vor} = \left(1 - \underline{\delta}_X\right) \cdot \left(\sum \underline{Z}_X + \underline{Z}_{\text{Rest,X}}\right)$$

**3 parallele Abgänge (Dokument VI)**

$$\underline{Z}_{X,vor} = \left(1 - \underline{\delta}_X\right) \cdot \left(\sum \underline{Z}_X + \underline{Z}_{\text{Rest,X}}\right)$$

---

**4 oder mehr parallele Abgänge (Dokument VII u. IV)**

$$\underline{Z}_{X,vor} = \left(1 - \underline{\delta}_X\right) \cdot \left(\sum \underline{Z}_X + \underline{Z}_{\text{Rest,X}}\right)$$

$$\underline{Z}_{AB\_CD,vor} = \sum \underline{Z}_{AB\_CD} + \underline{Z}_{C\|D} - \left(\underline{\delta}_A + \underline{\delta}_B\right) \cdot \left(\underline{Z}_{A\|B} + \sum \underline{Z}_{AB\_CD} + \underline{Z}_{C\|D}\right)$$

Fig. 2b

Entfernung vom Relais in % der Gesamtringlänge

Fig. 3

Fig. 4

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 60018666 T2
- CN 105891673 A
- CN 103149503 A
- US 2006097728 A1
- CN 203481822 U